# EUROPEAN PATENT APPLICATION

(11) **EP 3 758 054 A1**
(43) Date of publication of application: **30.12.2020**
(21) Application number: 20165762.4
(22) Date of filing: 26.03.2020
(51) Int. Cl.: H01L 21/8234, H01L 21/28, H01L 29/66, H01L 29/78, H01L 27/088

(54) **SELF-ALIGNED GATE ENDCAP (SAGE) ARCHITECTURE HAVING VERTICAL TRANSISTOR WITH SAGE GATE STRUCTURE**

(30) Priority: 27.06.2019 US 201916454398
(71) Applicant: INTEL Corporation, Santa Clara, CA 95054 (US)
(72) Inventor: HAFEZ, Walid M, Portland, Oregon 97229 (US); SUBRAMANIAN, Siaram, Portland, Oregon 97229 (US); JAN, Chia-Hong, Portland, Oregon 97229 (US)
(74) Representative: HGF

(57) **Abstract**

Self-aligned gate endcap (SAGE) architectures having vertical transistors with SAGE gate structures, and methods of fabricating SAGE architectures having vertical transistors with SAGE gate structures, are described. In an example, an integrated circuit structure includes a first semiconductor fin (304A) having first fin sidewall spacers (308A), and a second semiconductor fin (304B) having second fin sidewall spacers. A gate endcap structure is between the first and second semiconductor fins and laterally between and in contact with adjacent ones of the first and second fin sidewall spacers, the gate endcap structure including a gate electrode (312A) and a gate dielectric (310A). A first source or drain contact (402) is electrically coupled to the first semiconductor fin. A second source or drain contact is electrically coupled to the second semiconductor fin.

## Description

### TECHNICAL FIELD

Embodiments of the disclosure are in the field of integrated circuit structures and processing and, in particular, self-aligned gate endcap (SAGE) architectures having vertical transistors with SAGE gate structures, and methods of fabricating SAGE architectures having vertical transistors with SAGE gate structures.

### BACKGROUND

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for ever-more capacity, however, is not without issue. The necessity to optimize the performance of each device becomes increasingly significant.

In the manufacture of integrated circuit devices, multi-gate transistors, such as tri-gate transistors, have become more prevalent as device dimensions continue to scale down. In conventional processes, tri-gate transistors are generally fabricated on either bulk silicon substrates or silicon-on-insulator substrates. In some instances, bulk silicon substrates are preferred due to their lower cost and because they enable a less complicated tri-gate fabrication process.

Scaling multi-gate transistors has not been without consequence, however. As the dimensions of these fundamental building blocks of microelectronic circuitry are reduced and as the sheer number of fundamental building blocks fabricated in a given region is increased, the constraints on the lithographic processes used to pattern these building blocks have become overwhelming. In particular, there may be a trade-off between the smallest dimension of a feature patterned in a semiconductor stack (the critical dimension) and the spacing between such features. Additionally, the constraints on including passive features among active devices have increased.

### BRIEF DESCRIPTION OF THE DRAWINGS

Figure 1 illustrates a cross-sectional view of an integrated circuit structure including a logic device and a high voltage I/O device.
Figure 2 illustrates a cross-sectional view of an integrated circuit structure including a vertical transistor having a self-aligned gate endcap (SAGE) gate structure, in accordance with an embodiment of the present disclosure.
Figures 3A-3I illustrates cross-sectional views representing various operations in a method of fabricating an integrated circuit structure including a vertical transistor having a self-aligned gate endcap (SAGE) gate structure, in accordance with an embodiment of the present disclosure.
Figure 4 illustrates a cross-sectional view of an integrated circuit structure including a vertical transistor having a self-aligned gate endcap (SAGE) gate structure, in accordance with an embodiment of the present disclosure.
Figure 5 illustrates a cross-sectional view of an integrated circuit structure including a vertical transistor having a self-aligned gate endcap (SAGE) gate structure, in accordance with an embodiment of the present disclosure.
Figure 6 illustrates a plan view of a layout including fin-based integrated circuit structures accommodating end-to-end spacing.
Figures 7A-7D illustrate cross-sectional views of process operations of significance in a conventional finFET or tri-gate process fabrication scheme.
Figures 8A-8D illustrate cross-sectional views of process operations of significance in a self-aligned gate endcap (SAGE) process fabrication scheme for finFET or tri-gate devices, in accordance with an embodiment of the present disclosure.
Figure 9 illustrates a computing device in accordance with one implementation of the disclosure.
Figure 10 illustrates an interposer that includes one or more embodiments of the disclosure.
Figure 11 is an isometric view of a mobile computing platform employing an IC fabricated according to one or more processes described herein or including one or more features described herein, in accordance with an embodiment of the present disclosure.
Figure 12 illustrates a cross-sectional view of a flip-chip mounted die, in accordance with an embodiment of the present disclosure.

### DESCRIPTION OF THE EMBODIMENTS

Self-aligned gate endcap (SAGE) architectures having vertical transistors with SAGE gate structures, and methods of fabricating SAGE architectures having vertical transistors with SAGE gate structures, are described. In the following description, numerous specific details are set forth, such as specific integration and material regimes, in order to provide a thorough understanding of embodiments of the present disclosure. It will be apparent to one skilled in the art that embodiments of the present disclosure may be practiced without these specific details. In other instances, well-known features, such as integrated circuit design layouts, are not described in detail in order to not unnecessarily obscure embodiments of the present disclosure. Furthermore, it is to be appreciated that the various embodiments shown in the Figures are illustrative representations and are not necessarily drawn to scale.

Certain terminology may also be used in the following description for the purpose of reference only, and thus are not intended to be limiting. For example, terms such as "upper", "lower", "above", and "below" refer to directions in the drawings to which reference is made. Terms such as "front", "back", "rear", and "side" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

Embodiments described herein may be directed to front-end-of-line (FEOL) semiconductor processing and structures. FEOL is the first portion of integrated circuit (IC) fabrication where the individual devices (e.g., transistors, capacitors, resistors, etc.) are patterned in the semiconductor substrate or layer. FEOL generally covers everything up to (but not including) the deposition of metal interconnect layers. Following the last FEOL operation, the result is typically a wafer with isolated transistors (e.g., without any wires).

Embodiments described herein may be directed to back end of line (BEOL) semiconductor processing and structures. BEOL is the second portion of IC fabrication where the individual devices (e.g., transistors, capacitors, resistors, etc.) are interconnected with wiring on the wafer, e.g., the metallization layer or layers. BEOL includes contacts, insulating layers (dielectrics), metal levels, and bonding sites for chip-to-package connections. In the BEOL part of the fabrication stage contacts (pads), interconnect wires, vias and dielectric structures are formed. For modern IC processes, more than 10 metal layers may be added in the BEOL.

Embodiments described below may be applicable to FEOL processing and structures, BEOL processing and structures, or both FEOL and BEOL processing and structures. In particular, although an exemplary processing scheme may be illustrated using a FEOL processing scenario, such approaches may also be applicable to BEOL processing. Likewise, although an exemplary processing scheme may be illustrated using a BEOL processing scenario, such approaches may also be applicable to FEOL processing.

One or more embodiments of the present disclosure are directed to integrated circuit structures or devices having one or more gate endcap structures (e.g., as gate isolation regions) of gate electrodes of the integrated circuit structures or devices. The gate endcap structures may be self-aligned gate endcap (SAGE) walls formed between and in parallel alignment with a plurality of semiconductor fins. In an embodiment, the fabrication of gate electrodes in locations of select ones of the SAGE walls for the fabrication of high voltage vertical transistors using a SAGE structure as a gate electrode is described.

In accordance with one or more embodiments of the present disclosure, the integration of high voltage, long channel I/O devices into a SAGE architecture is described. By using a SAGE wall as a gate electrode, a device can be oriented vertically to incorporate both a diffused drain and long gate length for supporting high voltage operation. To provide context, traditional solutions rely on standard CMOS reverse-scaling that require multiple channel lengths to be supported. Logic CDs (i.e., narrow gates) and high voltage devices (i.e., long channel gate CDs) need to be fabricated simultaneously, often with the high voltage devices coupled with low doped drains to support high fields. A possible disadvantage of such devices on the SAGE architecture is the strict control of vertical recesses to integrate into the SAGE process. Processes for large and narrow gate CDs are difficult to control simultaneously, and can require costly addition of masking layers to separate into isolated processing segments.

In one or more embodiments described herein, a SAGE structure is used as a gate electrode. By filling a SAGE core with a conductor at a SAGE wall location, the conductor structure can act as a gate terminal. A high voltage device can be constructed vertically along a fin to maximize the overlap of the fin and SAGE gate electrode. Thus, embodiments described herein provide an alternative path for high voltage device integration into the SAGE architecture. The resulting construct can eliminate vertical control difficulties that manifest with standard high voltage CMOS integrating into a SAGE architecture. In one embodiment, for particular gate lengths, a vertical SAGE device can support higher voltages at smaller dimensions than traditional architectures.

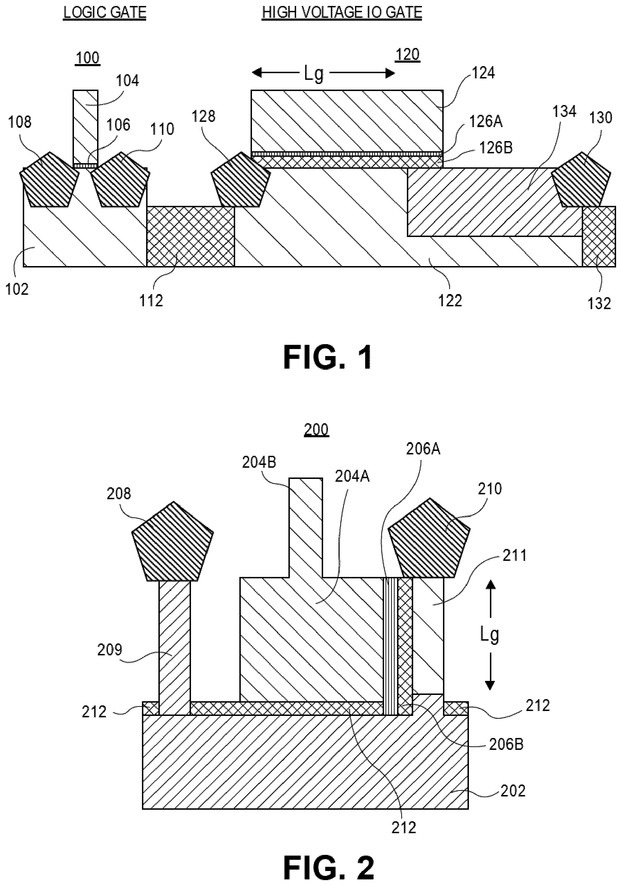

As a comparative example, Figure 1 illustrates a cross-sectional view of an integrated circuit structure including a logic device 100 and a high voltage I/O device 120.

Referring to Figure 1, the logic device 100 is formed on a first fin 102. The logic device 100 includes a gate electrode 104 on a relatively thin gate dielectric layer 106 on the fin 102. A source structure 108 is in the fin 102 at a first side of the gate electrode 104. A drain structure 110 is in the fin 102 at a second side of the gate electrode 104.

The high voltage I/O device 120 is formed on a second fin 122 separated from the first fin 102 by an isolation structure 112 and from other structures by an isolation structure 132. The high voltage I/O device 120 includes a gate electrode 124 on a relatively thick gate dielectric layer (e.g., including a by layer 126A/126B) on the fin 122. A source structure 128 is in the fin 122 at a first side of the gate electrode 124. A drain structure 130 is in the fin 122 at a second side of the gate electrode 124. An N-doped well (Nwell) 134 spaces the drain structure 130 from the second side of the gate electrode 124. The gate length (Lg) is depicted by the arrows.

With reference to Figure 1, a state-of-the-art approach for forming high voltage devices is to increase the gate length and oxide thickness. A traditional transistor has horizontal current flow (along the Lg arrows) under the gate. Typically, such devices are fabricated at a pitch multiple of the logic device. Common pitch multiples for 1.8V devices are 4-6X of the logic pitch, and 3.3V and higher would be upwards of 8-10x of the logic pitch. As logic pitches continue to scale, such discrepancy in gate critical dimension (CD) renders fabrication increasingly difficult due to within-die process issues.

Alternatively, in accordance with embodiments described herein, while transistors are scaling in the horizontal directions, they are increasing in dimensions in the vertical. Taller fins enable more drive current per unit area. By utilizing the increasing fin height, e.g., upwards of 100-200 nm, long channel transistors can be vertically constructed to efficiently use the fin. Furthermore, the transistor width in such structures is no longer quantized but a function of the fin length.

As an example of a vertical SAGE transistor, Figure 2 illustrates a cross-sectional view of an integrated circuit structure including a vertical transistor having a self-aligned gate endcap (SAGE) gate structure, in accordance with an embodiment of the present disclosure.

Referring to Figure 2, an integrated circuit structure 200 includes a substrate 202, which may have an Nwell formed therein. A gate electrode 204A is above the substrate 202 and between a first fin (left fin) and a second fin (right fin). The gate length (Lg) is depicted by the arrows. A gate electrode extension 204B is electrically connected to the gate electrode 204A. A gate dielectric structure 206A/206B is between the gate electrode 204A and the second (right) fin. In one embodiment, the gate dielectric structure 206A/206B includes a high-k dielectric layer 206A and a silicon oxide layer 206B.

Referring again to Figure 2, an epitaxial drain structure 208 is on the first (left) fin. An Nwell 209 is in the first (left) fin. An epitaxial source structure 210 is on the second (right) fin. A dielectric layer 212 separates the gate electrode 204A from the substrate 202. A Pwell 211 is in the second (right) fin. The dielectric layer 212 may be an extension of one or both of high-k dielectric layer 206A and silicon oxide layer 206B.

With reference again to Figure 2, in accordance with an embodiment of the present disclosure, a transistor is mirrored to improve symmetry and density. The drain voltage will be dropped across the Nwell down the fin and under the SAGE electrode. Such a scenario is similar to VDMOS/EDMOS implementations in earlier technologies, and allows higher voltage to be applied to the drain without compromising the drain/gate oxide breakdown. Under the proper gate bias, the P-type fin will invert near the gate edge, and allow conduction to the source. The gate channel length is defined as the height of the Pwell region in the fin, bracketed by N+ epi for the source and the NWL layer below for the drain.

With reference again to Figure 2, in accordance with an embodiment of the present disclosure, an integrated circuit structure 200 includes a drain structure having a first epitaxial structure 208 on a first semiconductor fin 209 and a doped region in a substrate 202 below the first semiconductor fin 209. A channel structure includes at least a portion of the second semiconductor fin 211. A source structure includes a second epitaxial structure 210 on the second semiconductor fin 211. A gate structure is between the first 209 and second 211 semiconductor fins, the gate structure including a gate electrode 204A and a gate dielectric 206A/206B.

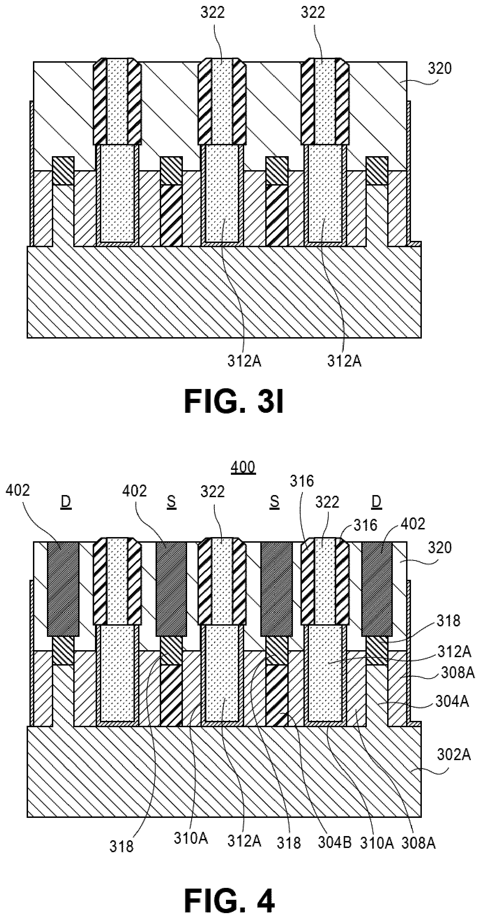

In an embodiment, although not depicted in Figure 2 but is described below in association with Figure 4, the integrated circuit structure 200 further includes a drain contact on the first epitaxial structure 208, and a source contact on the second epitaxial structure 210. In an embodiment, the drain structure and the source structure are N-type, and the channel structure is P-type. In an embodiment, the integrated circuit structure 200 further includes a gate extension 204B on the gate structure, the gate extension 204B electrically connected to the gate electrode 204A of the gate structure.

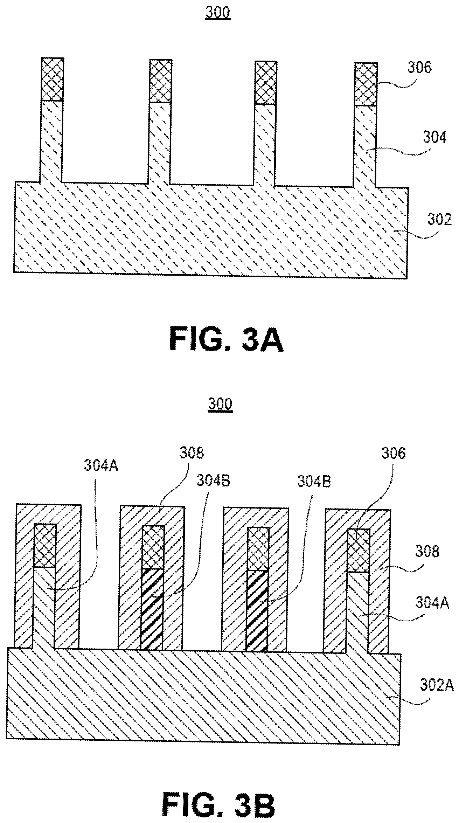

As an exemplary processing scheme, Figures 3A-3I illustrates cross-sectional views representing various operations in a method of fabricating an integrated circuit structure including a vertical transistor having a self-aligned gate endcap (SAGE) gate structure, in accordance with an embodiment of the present disclosure. Figure 4 illustrates a cross-sectional view of an integrated circuit structure including a vertical transistor having a self-aligned gate endcap (SAGE) gate structure, in accordance with an embodiment of the present disclosure.

Referring to Figure 3A, a starting structure 300 includes fins 304 formed to protrude from a substrate 302. A hardmask 306 is retained on the fins 304.

Referring to Figure 3B, implanting operations (e.g., ion implantation or solid-state doping) are performed on structure 300 to form N-type substrate 302A, N-type fins 304A, and P-type fins 304B. A spacer material 308 is formed over each of the N-type fins 304A and P-type fins 304B and over the hardmask 306. The spacer material 308 may be patterned or formed as patterned to provide discrete regions of spacer material 308 between adjacent fins. Alternatively, the spacer material 308 may be formed as and retained as continuous between adjacent fins. In either case, in one embodiment, the spacer material 308 ultimately is used as a primary high voltage dielectric in the final fabricated structure, e.g., as a gate dielectric between a metallic SAGE core and an adjacent fin.

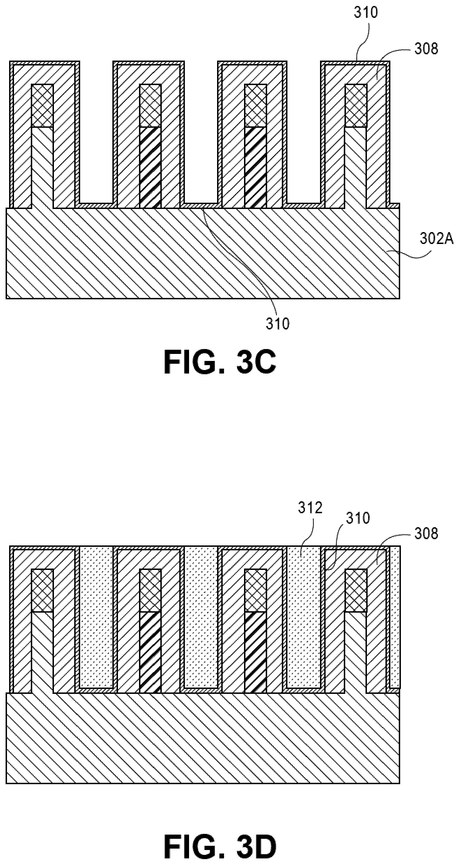

Referring to Figure 3C, a first portion 310 of a gate structure is formed over the structure of Figure 3B. The first portion 310 of the gate stack can include a high-k dielectric layer and may further include a workfunction gate electrode layer.

Referring to Figure 3D, a metal fill is performed on the structure of Figure 3C to provide a conductive or metallic SAGE core 312. The metal fill may be performed using a deposition and planarization process.

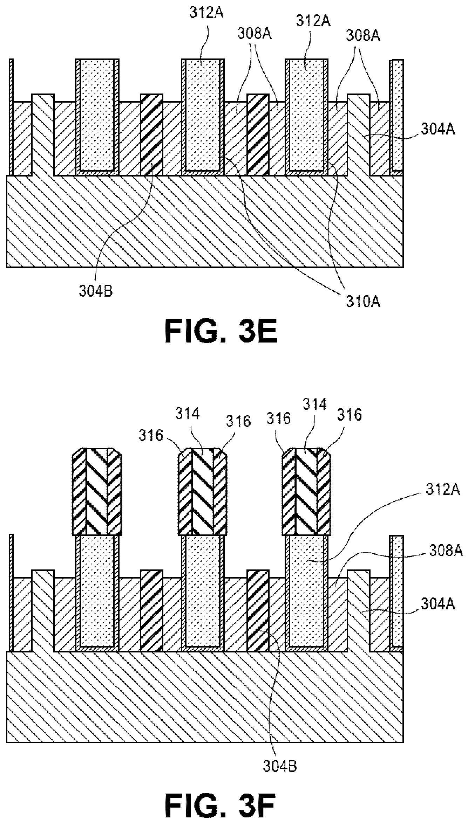

Referring to Figure 3E, the spacer material 308 is recessed to form recessed spacer material 308A. The hardmask material 306 is also removed from the fins 304A and 304B. The conductive or metallic SAGE core 312 may be slightly recessed in the process to form recessed conductive or metallic SAGE core 312A.

Referring to Figure 3F, dummy gate electrode extensions 314 are formed on the tops of conductive or metallic SAGE cores 312A. In one embodiment, the dummy gate electrode extensions 314 are formed by depositing and then patterning a polysilicon layer over the structure of Figure 3E. Once patterned, dielectric spacers 316 may be formed along the sidewalls of the dummy gate electrode extensions 314, as is depicted.

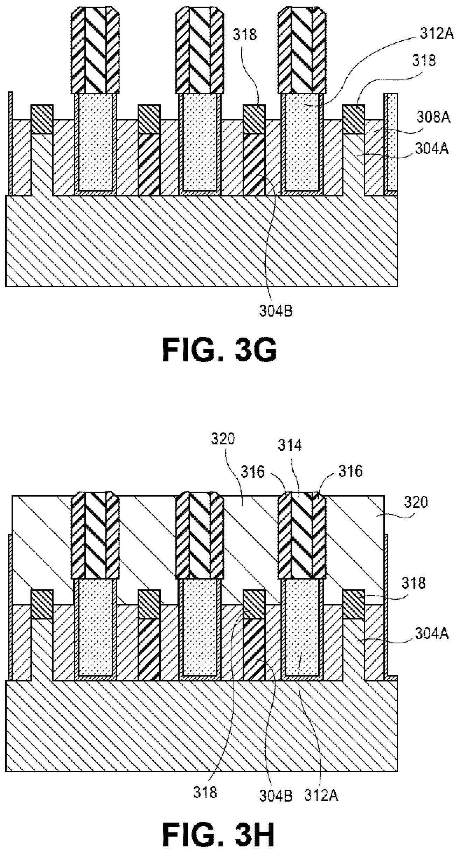

Referring to Figure 3G, epitaxial source and drain extensions 318 are formed on the tops of the fins 304A and 304B. In one embodiment, the epitaxial source and drain extensions 318 are N-type silicon epitaxial source and drain extensions.

Referring to Figure 3H, an inter-layer dielectric material 320 is formed over the structure of Figure 3G. In one embodiment, the inter-layer dielectric material 320 is formed using a deposition and planarization process.

Referring to Figure 3I, the dummy gate electrode extensions 314 are removed and replaced with a conductive and/or metallic material to form conductive gate electrode extensions 322. It is to be appreciated that, in accordance with an embodiment, a gate dielectric is not included between conductive gate electrode extensions 322 and the conductive or metallic SAGE cores 312A, e.g., to enable formation of an electrical contact between respective pairs of conductive gate electrode extensions 322 and conductive or metallic SAGE cores 312A to provide a gate electrode for a vertical transistor.

Referring to Figure 4, source or drain contacts 402 are formed to contact the epitaxial source and drain extensions 318. In one embodiment, the source or drain contacts 402 are trench source or drain contacts 402.

With reference again to Figure 4, in accordance with an embodiment of the present disclosure, an integrated circuit structure 400 includes a first semiconductor fin (furthest fin to the left) having first fin sidewall spacers 308A, and a second semiconductor fin (next fin in from left) having second fin sidewall spacers 308A. A gate endcap structure is between the first and second semiconductor fins and laterally between and in contact with adjacent ones of the first and second fin sidewall spacers 308A. The gate endcap structure includes a gate electrode 312A and a gate dielectric 310A. A first source or drain contact 402 (e.g., drain contact (D) on left) is electrically coupled to the first semiconductor fin. A second source or drain contact (e.g., source contact (S) on left) is electrically coupled to the second semiconductor fin.

In an embodiment, integrated circuit structure 400 further includes a first epitaxial semiconductor structure 318 on the first semiconductor fin, and the first source or drain contact is on the first epitaxial semiconductor structure. A second epitaxial semiconductor structure 318 is on the second semiconductor fin, and the second source or drain contact is on the second epitaxial semiconductor structure.

In an embodiment, the gate endcap structure is on an N-type doped region of an underlying substrate 302A, the first semiconductor fin includes an N-type region 304A, and the second semiconductor fin includes a P-type region 304B. In one such embodiment, a first N-type epitaxial semiconductor structure 318 on the first semiconductor fin, and the first source or drain contact is on the first N-type epitaxial semiconductor structure. A second N-type epitaxial semiconductor structure 318 is on the second semiconductor fin, and the second source or drain contact is on the second N-type epitaxial semiconductor structure.

In an embodiment, the gate endcap structure has a top surface above a top surface of the first semiconductor fin, and above a top surface of the second semiconductor fin, as is depicted in Figure 4. In an embodiment, a gate extension 322 is on the gate endcap structure, the gate extension 322 electrically connected to the gate electrode 312A of the gate endcap structure. In one such embodiment, wherein the gate extension 322 includes dielectric sidewall spacers 316.

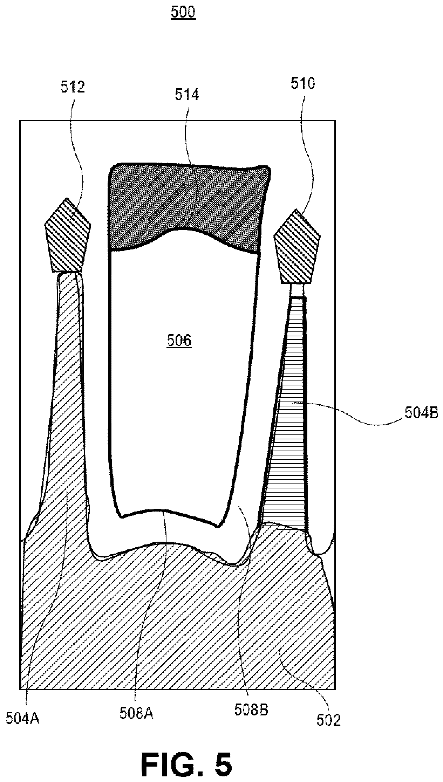

It is to be appreciated that an actually fabricated device may not have an idealized geometry. As an example, Figure 5 illustrates a cross-sectional view of an integrated circuit structure including a vertical transistor having a self-aligned gate endcap (SAGE) gate structure, in accordance with an embodiment of the present disclosure.

Referring to Figure 5, an integrated circuit structure 500 includes a substrate 502 having an Nwell therein. A first fin 504A and a second fin 504B protrude from the substrate 502. The first fin has an extension of the Nwell. The second fin 504B has a Pwell region therein (as highlighted by the overlaying shaded region. A gate electrode 506 is between the first fin 504A and the second fin 504B. The gate electrode is on and adjacent to a gate dielectric structure which can include a high-k dielectric layer 508A and a thick silicon oxide layer 508B. An epitaxial drain structure 512 is on the first fin 504A. An epitaxial source structure 510 is on the second fin 504B. A gate cap layer 514 may be on the gate electrode 506, as is depicted.

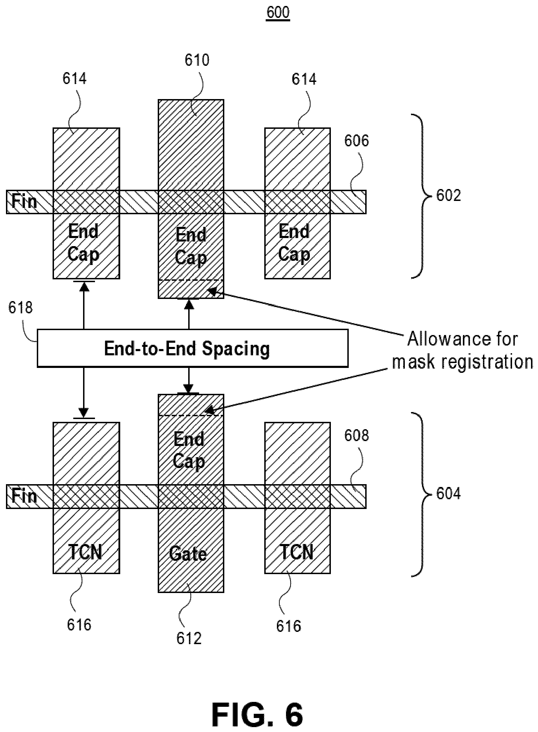

To provide a foundation for SAGE concepts relevant to embodiments described herein, scaling of gate endcap and trench contact (TCN) endcap regions are important contributors towards improving transistor layout area and density. Gate and TCN endcap regions refer to gate and TCN overlap of the diffusion region/fins of integrated circuit structures. As an example, Figure 6 illustrates a plan view of a layout 600 including fin-based integrated circuit structures accommodating end-to-end spacing. Referring to Figure 6, first 602 and second 604 integrated circuit structures are based on semiconductor fins 606 and 608, respectively. Each device 602 and 604 has a gate electrode 610 or 612, respectively. Additionally, each device 602 and 604 has trench contacts (TCNs) 614 and 616, respectively, at source and drain regions of the fins 606 and 608, respectively. The gate electrodes 610 and 612 and the TCNs 614 and 616 each have an end cap region, which is located off of the corresponding fins 606 and 608, respectively.

Referring again to Figure 6, typically, gate and TCN endcap dimensions must include an allowance for mask registration error to ensure robust transistor operation for worst case mask mis-registration, leaving an end-to-end spacing 618. Thus, another important design rule critical to improving transistor layout density is the spacing between two adjacent endcaps facing each other. However, the parameters of "*2*Endcap* + *End-to-End Spacing*" are becoming increasingly difficult to scale using lithographic patterning to meet the scaling requirements for new technologies. In particular, the additional endcap length required to allow for mask registration error also increases gate capacitance values due to longer overlap length between TCN and gate electrodes, thereby increasing product dynamic energy consumption and degrading performance. Previous solutions have focused on improving registration budget and patterning or resolution improvements to enable shrinkage of both endcap dimension and endcap-to-endcap spacing.

In accordance with an embodiment of the present disclosure, approaches are described which provide for self-aligned gate endcap and TCN overlap of a semiconductor fin without any need to allow for mask registration. In one such embodiment, a disposable spacer is fabricated on the semiconductor fin endcaps which determines the gate endcap and the contact overlap dimensions. The spacer defined endcap process enables the gate and TCN endcap regions to be self-aligned to the semiconductor fin and, therefore, does not require extra endcap length to account for mask mis-registration. Furthermore, approaches described herein do not require lithographic patterning at previously required stages since the gate and TCN endcap/overlap dimensions remain fixed, leading to improvement (i.e., reduction) in device to device variability in electrical parameters.

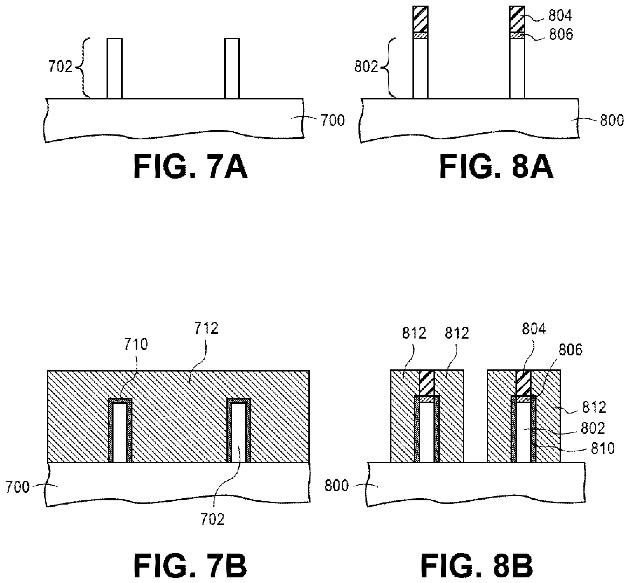

In order to provide a side-by-side comparison, Figures 7A-7D illustrate cross-sectional views of process operations of significance in a conventional finFET or tri-gate process fabrication scheme, while Figures 8A-8D illustrate cross-sectional views of process operations of significance in a self-aligned gate endcap (SAGE) process fabrication scheme for finFET or tri-gate devices, in accordance with an embodiment of the present disclosure.

Referring to Figures 7A and 8A, a bulk semiconductor substrate 700 or 800, such as a bulk single crystalline silicon substrate is provided having fins 702 or 802, respectively, etched therein. In an embodiment, the fins are formed directly in the bulk substrate 700 or 800 and, as such, are formed continuous with the bulk substrate 700 or 800. It is to be appreciated that within the substrate 700 or 800, shallow trench isolation structures may be formed between fins. Referring to Figure 8A, a hardmask layer 804, such as a silicon nitride hardmask layer, and a pad oxide layer 806, such as a silicon dioxide layer, remain atop fins 802 following patterning to form the fins 802. By contrast, referring to Figure 7A, such a hardmask layer and pad oxide layer have been removed.

Referring to Figure 7B, a dummy or permanent gate dielectric layer 710 is formed on the exposed surfaces of the semiconductor fins 702, and a dummy gate layer 712 is formed over the resulting structure. By contrast, referring to Figure 8B, a dummy or permanent gate dielectric layer 810 is formed on the exposed surfaces of the semiconductor fins 802, and dummy spacers 812 are formed adjacent to the resulting structure.

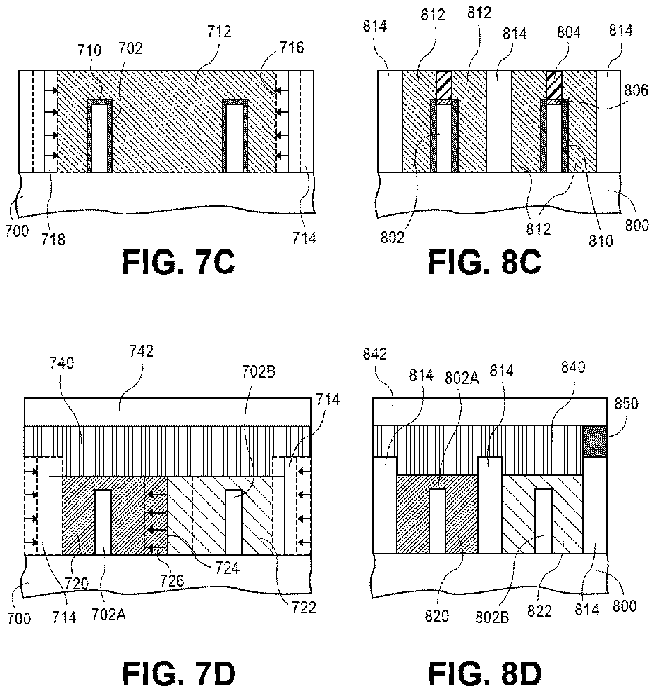

Referring to Figure 7C, gate endcap cut patterning is performed and isolation regions 714 are formed at the resulting patterned dummy gate ends 716. In the conventional process scheme, a larger gate endcap must be fabricated to allow for gate mask mis-registration, as depicted by the arrowed regions 718. By contrast, referring to Figure 8C, self-aligned isolation regions 814 are formed by providing an isolation layer over the structure of Figure 8B, e.g., by deposition and planarization. In one such embodiment, the self-aligned gate endcap process does not require extra space for mask registration, as compared in Figures 7C and 8C.

Referring to Figure 7D, the dummy gate electrode 712 of Figure 7C is replaced with permanent gate electrodes. In the case of use of a dummy gate dielectric layer, such a dummy gate dielectric layer may also be replaced by a permanent gate dielectric layer in this process. In the specific example shown, a dual metal gate replacement process is performed to provide an N-type gate electrode 720 over a first semiconductor fin 702A and to provide a P-type gate electrode 722 over a second semiconductor fin 702B. The N-type gate electrode 720 and the P-type gate electrode 722 are formed between the gate endcap isolations structures 714, but form a P/N junction 724 where they meet. The exact location of the P/N junction 724 may vary, depending on mis-registration, as depicted by the arrowed region 726.

By contrast, referring to Figure 8D, the hardmask layer 804 and pad oxide layer 806 are removed, and the dummy spacers 814 of Figure 8C are replaced with permanent gate electrodes. In the case of use of a dummy gate dielectric layer, such a dummy gate dielectric layer may also be replaced by a permanent gate dielectric layer in this process. In the specific example shown, a dual metal gate replacement process is performed to provide an N-type gate electrode 820 over a first semiconductor fin 802A and to provide a P-type gate electrode 822 over a second semiconductor fin 802B. The N-type gate electrode 820 and the P-type gate electrode 822 are formed between, and are also separated by, the gate endcap isolations structures 814.

Referring again to Figure 7D, a local interconnect 740 may be fabricated to contact N-type gate electrode 720 and P-type gate electrode 722 to provide a conductive path around the P/N junction 724. Likewise, referring to Figure 8D, a local interconnect 840 may be fabricated to contact N-type gate electrode 820 and P-type gate electrode 822 to provide a conductive path over the intervening isolation structure 814 there between. Referring to both Figures 7D and 8D, a hardmask 742 or 842 may be formed on the local interconnect 740 or 840, respectively. Referring to Figure 8D in particular, in an embodiment, the continuity of the local interconnect 840 is interrupted by a dielectric plug 850 in cases where a break in electrical contact along a gate line are needed. As used, herein, the term "plug" is used to refer to a non-conductive space or interruption of a metal or otherwise conductive structure, such as an interruption of a local interconnect feature.

In accordance with one or more embodiments of the present disclosure, a logic structure such as described in association with Figure 8D is fabricated on a same substrate as an I/O device such as described in association with Figures 2, 4 or 5. The I/O device may have a gate electrode fabricated in a location corresponding to a dielectric SAGE wall of a logic device.

In accordance with one or more embodiments of the present disclosure, a self-aligned gate endcap (SAGE) processing scheme involves the formation of gate/trench contact endcaps self-aligned to fins without requiring an extra length to account for mask mis-registration. Thus, embodiments may be implemented to enable shrinking of transistor layout area. Furthermore, a flexible fin-height (e.g., multi Hsi) process may enable independent optimization of different cells for power and performance. An integrated process flow enabling both features may be implemented to meet scaling and performance challenges for future CMOS technology. Embodiments described herein may involve the fabrication of gate endcap isolation structures, which may also be referred to as gate walls or SAGE walls.

More generally, one or more embodiments described herein provide an avenue for area scaling, reducing capacitance, and/or eliminating various critical front end masks, such as gate cut masks. In one such embodiment the width of a minimum transistor can be reduced by up to 30% by implementing one or more of the approaches describe herein. The smaller transistor size reduces the capacitance between the gate and TCN and other parasitic capacitances. In one embodiment, no extra mask operations are needed to create the endcaps, contacts and local interconnect lines so the many masks needed for such features in the standard process are eliminated.

More specifically, key features of one or more embodiments described above may include one or more of: (1) the gate endcap is the distance from the fin endcap to the isolation endcap. This distance is defined by the spacer width and is the same size for all transistors. No lithographic patterning is needed to define the endcap so there is no need to allow for mask registration in the endcap; (2) The TCN overlap of the fin is determined by the spacer width and is also not affected by mask registration. Embodiments may be applicable to the 7nm node generation, e.g., to improve transistor layout density and gate capacitance (dynamic energy and performance improvement) and reduce total mask count. It is to be appreciated that the structures resulting from the above exemplary processing schemes may be used in a same or similar form for subsequent processing operations to complete device fabrication, such as PMOS and NMOS device fabrication.

As described throughout the present application, a substrate may be composed of a semiconductor material that can withstand a manufacturing process and in which charge can migrate. In an embodiment, a substrate is described herein is a bulk substrate composed of a crystalline silicon, silicon/germanium or germanium layer doped with a charge carrier, such as but not limited to phosphorus, arsenic, boron or a combination thereof, to form an active region. In one embodiment, the concentration of silicon atoms in such a bulk substrate is greater than 97%. In another embodiment, a bulk substrate is composed of an epitaxial layer grown atop a distinct crystalline substrate, e.g. a silicon epitaxial layer grown atop a boron-doped bulk silicon mono-crystalline substrate. A bulk substrate may alternatively be composed of a group III-V material. In an embodiment, a bulk substrate is composed of a III-V material such as, but not limited to, gallium nitride, gallium phosphide, gallium arsenide, indium phosphide, indium antimonide, indium gallium arsenide, aluminum gallium arsenide, indium gallium phosphide, or a combination thereof. In one embodiment, a bulk substrate is composed of a III-V material and the charge-carrier dopant impurity atoms are ones such as, but not limited to, carbon, silicon, germanium, oxygen, sulfur, selenium or tellurium.

As described throughout the present application, gate lines or gate structures may be composed of a gate electrode stack which includes a gate dielectric layer and a gate electrode layer. In an embodiment, the gate electrode of the gate electrode stack is composed of a metal gate and the gate dielectric layer is composed of a high-k material. For example, in one embodiment, the gate dielectric layer is composed of a material such as, but not limited to, hafnium oxide, hafnium oxy-nitride, hafnium silicate, lanthanum oxide, zirconium oxide, zirconium silicate, tantalum oxide, barium strontium titanate, barium titanate, strontium titanate, yttrium oxide, aluminum oxide, lead scandium tantalum oxide, lead zinc niobate, or a combination thereof. Furthermore, a portion of the gate dielectric layer may include a layer of native oxide formed from the top few layers of a semiconductor substrate. In an embodiment, the gate dielectric layer is composed of a top high-k portion and a lower portion composed of an oxide of a semiconductor material. In one embodiment, the gate dielectric layer is composed of a top portion of hafnium oxide and a bottom portion of silicon dioxide or silicon oxy-nitride. In some implementations, a portion of the gate dielectric is a "U"-shaped structure that includes a bottom portion substantially parallel to the surface of the substrate and two sidewall portions that are substantially perpendicular to the top surface of the substrate.

In one embodiment, a gate electrode is composed of a metal layer such as, but not limited to, metal nitrides, metal carbides, metal silicides, metal aluminides, hafnium, zirconium, titanium, tantalum, aluminum, ruthenium, palladium, platinum, cobalt, nickel or conductive metal oxides. In a specific embodiment, the gate electrode is composed of a non-workfunction-setting fill material formed above a metal workfunction-setting layer. The gate electrode layer may consist of a P-type workfunction metal or an N-type workfunction metal, depending on whether the transistor is to be a PMOS or an NMOS transistor. In some implementations, the gate electrode layer may consist of a stack of two or more metal layers, where one or more metal layers are workfunction metal layers and at least one metal layer is a conductive fill layer. For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 eV and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, and aluminum carbide. An N-type metal layer will enable the formation of an NMOS gate electrode with a workfunction that is between about 3.9 eV and about 4.2 eV. In some implementations, the gate electrode may consist of a "U"-shaped structure that includes a bottom portion substantially parallel to the surface of the substrate and two sidewall portions that are substantially perpendicular to the top surface of the substrate. In another implementation, at least one of the metal layers that form the gate electrode may simply be a planar layer that is substantially parallel to the top surface of the substrate and does not include sidewall portions substantially perpendicular to the top surface of the substrate. In further implementations of the disclosure, the gate electrode may consist of a combination of U-shaped structures and planar, non-U-shaped structures. For example, the gate electrode may consist of one or more U-shaped metal layers formed atop one or more planar, non-U-shaped layers.

As described throughout the present application, spacers associated with gate lines or electrode stacks may be composed of a material suitable to ultimately electrically isolate, or contribute to the isolation of, a permanent gate structure from adjacent conductive contacts, such as self-aligned contacts. For example, in one embodiment, the spacers are composed of a dielectric material such as, but not limited to, silicon dioxide, silicon oxy-nitride, silicon nitride, or carbon-doped silicon nitride.

As described throughout the present application, isolation regions such as shallow trench isolation regions or sub-fin isolation regions may be composed of a material suitable to ultimately electrically isolate, or contribute to the isolation of, portions of a permanent gate structure from an underlying bulk substrate or to isolate active regions formed within an underlying bulk substrate, such as isolating fin active regions. For example, in one embodiment, an isolation region is composed of one or more layers of a dielectric material such as, but not limited to, silicon dioxide, silicon oxy-nitride, silicon nitride, carbon-doped silicon nitride, or a combination thereof.

In an embodiment, as described throughout, self-aligned gate endcap isolation structures may be composed of a material or materials suitable to ultimately electrically isolate, or contribute to the isolation of, portions of permanent gate structures from one another. Exemplary materials or material combinations include a single material structure such as silicon dioxide, silicon oxy-nitride, silicon nitride, or carbon-doped silicon nitride. Other exemplary materials or material combinations include a multi-layer stack having lower portion silicon dioxide, silicon oxy-nitride, silicon nitride, or carbon-doped silicon nitride and an upper portion higher dielectric constant material such as hafnium oxide. It is to be appreciated that, SAGE walls of varying width may be fabricated, e.g., to provide relatively narrow SAGE walls and relatively wide SAGE walls. It is also to be appreciated that fabrication of gate endcap isolation structures may lead to formation of a seam within the gate endcap isolation structures. It is also to be appreciated that gate endcap isolation structures may differ depending on the spacing of adjacent fins.

In an embodiment, approaches described herein may involve formation of a contact pattern which is very well aligned to an existing gate pattern while eliminating the use of a lithographic operation with exceedingly tight registration budget. In one such embodiment, this approach enables the use of intrinsically highly selective wet etching (e.g., versus dry or plasma etching) to generate contact openings. In an embodiment, a contact pattern is formed by utilizing an existing gate pattern in combination with a contact plug lithography operation. In one such embodiment, the approach enables elimination of the need for an otherwise critical lithography operation to generate a contact pattern, as used in other approaches. In an embodiment, a trench contact grid is not separately patterned, but is rather formed between poly (gate) lines. For example, in one such embodiment, a trench contact grid is formed subsequent to gate grating patterning but prior to gate grating cuts.

In some embodiments, the arrangement of a semiconductor structure or device places a gate contact over portions of a gate line or gate stack over isolation regions. However, such an arrangement may be viewed as inefficient use of layout space. In another embodiment, a semiconductor device has contact structures that contact portions of a gate electrode formed over an active region. Thus, contact over active gate (COAG) structures may be fabricated. One or more embodiments of the present disclosure are directed to semiconductor structures or devices having one or more gate contact structures (e.g., as gate contact vias) disposed over active portions of gate electrodes of the semiconductor structures or devices. One or more embodiments of the present disclosure are directed to methods of fabricating semiconductor structures or devices having one or more gate contact structures formed over active portions of gate electrodes of the semiconductor structures or devices. Approaches described herein may be used to reduce a standard cell area by enabling gate contact formation over active gate regions. In one or more embodiments, the gate contact structures fabricated to contact the gate electrodes are self-aligned via structures.

More generally, one or more embodiments are directed to approaches for, and structures formed from, landing a gate contact via directly on an active transistor gate. Such approaches may eliminate the need for extension of a gate line on isolation for contact purposes. Such approaches may also eliminate the need for a separate gate contact (GCN) layer to conduct signals from a gate line or structure. In an embodiment, eliminating the above features is achieved by recessing contact metals in a trench contact (TCN) and introducing an additional dielectric material in the process flow (e.g., TILA). The additional dielectric material is included as a trench contact dielectric cap layer with etch characteristics different from the gate dielectric material cap layer already used for trench contact alignment in a gate aligned contact process (GAP) processing scheme (e.g., GILA). However, in technologies where space and layout constraints are somewhat relaxed compared with current generation space and layout constraints, a contact to gate structure may be fabricated by making contact to a portion of the gate electrode disposed over an isolation region.

Furthermore, a gate stack structure may be fabricated by a replacement gate process. In such a scheme, dummy gate material such as polysilicon or silicon nitride pillar material, may be removed and replaced with permanent gate electrode material. In one such embodiment, a permanent gate dielectric layer is also formed in this process, as opposed to being carried through from earlier processing. In an embodiment, dummy gates are removed by a dry etch or wet etch process. In one embodiment, dummy gates are composed of polycrystalline silicon or amorphous silicon and are removed with a dry etch process including use of SF₆. In another embodiment, dummy gates are composed of polycrystalline silicon or amorphous silicon and are removed with a wet etch process including use of aqueous NH₄OH or tetramethylammonium hydroxide. In one embodiment, dummy gates are composed of silicon nitride and are removed with a wet etch including aqueous phosphoric acid.

In an embodiment, one or more approaches described herein contemplate essentially a dummy and replacement gate process in combination with a dummy and replacement contact process to arrive at structure. In one such embodiment, the replacement contact process is performed after the replacement gate process to allow high temperature anneal of at least a portion of the permanent gate stack. For example, in a specific such embodiment, an anneal of at least a portion of the permanent gate structures, e.g., after a gate dielectric layer is formed, is performed at a temperature greater than approximately 600 degrees Celsius. The anneal is performed prior to formation of the permanent contacts.

In an embodiment, as used throughout the present description, interlayer dielectric (ILD) material is composed of or includes a layer of a dielectric or insulating material. Examples of suitable dielectric materials include, but are not limited to, oxides of silicon (e.g., silicon dioxide (SiO₂)), doped oxides of silicon, fluorinated oxides of silicon, carbon doped oxides of silicon, various low-k dielectric materials known in the arts, and combinations thereof. The interlayer dielectric material may be formed by conventional techniques, such as, for example, chemical vapor deposition (CVD), physical vapor deposition (PVD), or by other deposition methods.

In an embodiment, as is also used throughout the present description, metal lines or interconnect line material (and via material) is composed of one or more metal or other conductive structures. A common example is the use of copper lines and structures that may or may not include barrier layers between the copper and surrounding ILD material. As used herein, the term metal includes alloys, stacks, and other combinations of multiple metals. For example, the metal interconnect lines may include barrier layers (e.g., layers including one or more of Ta, TaN, Ti or TiN), stacks of different metals or alloys, etc. Thus, the interconnect lines may be a single material layer, or may be formed from several layers, including conductive liner layers and fill layers. Any suitable deposition process, such as electroplating, chemical vapor deposition or physical vapor deposition, may be used to form interconnect lines. In an embodiment, the interconnect lines are composed of a conductive material such as, but not limited to, Cu, Al, Ti, Zr, Hf, V, Ru, Co, Ni, Pd, Pt, W, Ag, Au or alloys thereof. The interconnect lines are also sometimes referred to in the art as traces, wires, lines, metal, or simply interconnect.

In an embodiment, as is also used throughout the present description, hardmask materials, capping layers, or plugs are composed of dielectric materials different from the interlayer dielectric material. In one embodiment, different hardmask, capping or plug materials may be used in different regions so as to provide different growth or etch selectivity to each other and to the underlying dielectric and metal layers. In some embodiments, a hardmask layer, capping or plug layer includes a layer of a nitride of silicon (e.g., silicon nitride) or a layer of an oxide of silicon, or both, or a combination thereof. Other suitable materials may include carbon-based materials. Other hardmask, capping or plug layers known in the arts may be used depending upon the particular implementation. The hardmask, capping or plug layers may be formed by CVD, PVD, or by other deposition methods.

In an embodiment, as is also used throughout the present description, lithographic operations are performed using 193nm immersion litho (i193), EUV and/or EBDW lithography, or the like. A positive tone or a negative tone resist may be used. In one embodiment, a lithographic mask is a trilayer mask composed of a topographic masking portion, an anti-reflective coating (ARC) layer, and a photoresist layer. In a particular such embodiment, the topographic masking portion is a carbon hardmask (CHM) layer and the anti-reflective coating layer is a silicon ARC layer.

Pitch division processing and patterning schemes may be implemented to enable embodiments described herein or may be included as part of embodiments described herein. Pitch division patterning typically refers to pitch halving, pitch quartering etc. Pitch division schemes may be applicable to FEOL processing, BEOL processing, or both FEOL (device) and BEOL (metallization) processing. In accordance with one or more embodiments described herein, optical lithography is first implemented to print unidirectional lines (e.g., either strictly unidirectional or predominantly unidirectional) in a pre-defined pitch. Pitch division processing is then implemented as a technique to increase line density.

In an embodiment, the term "grating structure" for fins, gate lines, metal lines, ILD lines or hardmask lines is used herein to refer to a tight pitch grating structure. In one such embodiment, the tight pitch is not achievable directly through a selected lithography. For example, a pattern based on a selected lithography may first be formed, but the pitch may be halved by the use of spacer mask patterning, as is known in the art. Even further, the original pitch may be quartered by a second round of spacer mask patterning. Accordingly, the grating-like patterns described herein may have metal lines, ILD lines or hardmask lines spaced at a substantially consistent pitch and having a substantially consistent width. For example, in some embodiments, the pitch variation would be within ten percent and the width variation would be within ten percent, and in some embodiments, the pitch variation would be within five percent and the width variation would be within five percent. The pattern may be fabricated by a pitch halving or pitch quartering, or other pitch division, approach. In an embodiment, the grating is not necessarily single pitch.

It is to be appreciated that not all aspects of the processes described above need be practiced to fall within the spirit and scope of embodiments of the present disclosure. For example, in one embodiment, dummy gates need not ever be formed prior to fabricating gate contacts over active portions of the gate stacks. The gate stacks described above may actually be permanent gate stacks as initially formed. Also, the processes described herein may be used to fabricate one or a plurality of semiconductor devices. The semiconductor devices may be transistors or like devices. For example, in an embodiment, the semiconductor devices are a metal-oxide semiconductor (MOS) transistors for logic or memory, or are bipolar transistors. Also, in an embodiment, the semiconductor devices have a three-dimensional architecture, such as a trigate device, an independently accessed double gate device, or a FIN-FET. One or more embodiments may be particularly useful for fabricating semiconductor devices at a 10 nanometer (10 nm) technology node sub-10 nanometer (10 nm) technology node.

Additional or intermediate operations for FEOL layer or structure fabrication (or BEOL layer or structure fabrication) may include standard microelectronic fabrication processes such as lithography, etch, thin films deposition, planarization (such as chemical mechanical polishing (CMP)), diffusion, metrology, the use of sacrificial layers, the use of etch stop layers, the use of planarization stop layers, or any other associated action with microelectronic component fabrication. Also, it is to be appreciated that the process operations described for the preceding process flows may be practiced in alternative sequences, not every operation need be performed or additional process operations may be performed, or both.

In an embodiment, as described throughout, an integrated circuit structure includes non-planar devices such as, but not limited to, a finFET or a tri-gate device. The non-planar devices may further include corresponding one or more overlying nanowire structures above the finFET or a tri-gate device. In such an embodiment, a corresponding semiconducting channel region is composed of or is formed in a three-dimensional body with one or more discrete nanowire channel portions overlying the three-dimensional body. In one such embodiment, the gate structures surround at least a top surface and a pair of sidewalls of the three-dimensional body, and further surrounds each of the one or more discrete nanowire channel portions.

Embodiments disclosed herein may be used to manufacture a wide variety of different types of integrated circuits or microelectronic devices. Examples of such integrated circuits include, but are not limited to, processors, chipset components, graphics processors, digital signal processors, micro-controllers, and the like. In other embodiments, semiconductor memory may be manufactured. Moreover, the integrated circuits or other microelectronic devices may be used in a wide variety of electronic devices known in the arts. For example, in computer systems (e.g., desktop, laptop, server), cellular phones, personal electronics, etc. The integrated circuits may be coupled with a bus and other components in the systems. For example, a processor may be coupled by one or more buses to a memory, a chipset, etc. Each of the processor, the memory, and the chipset, may potentially be manufactured using the approaches disclosed herein.

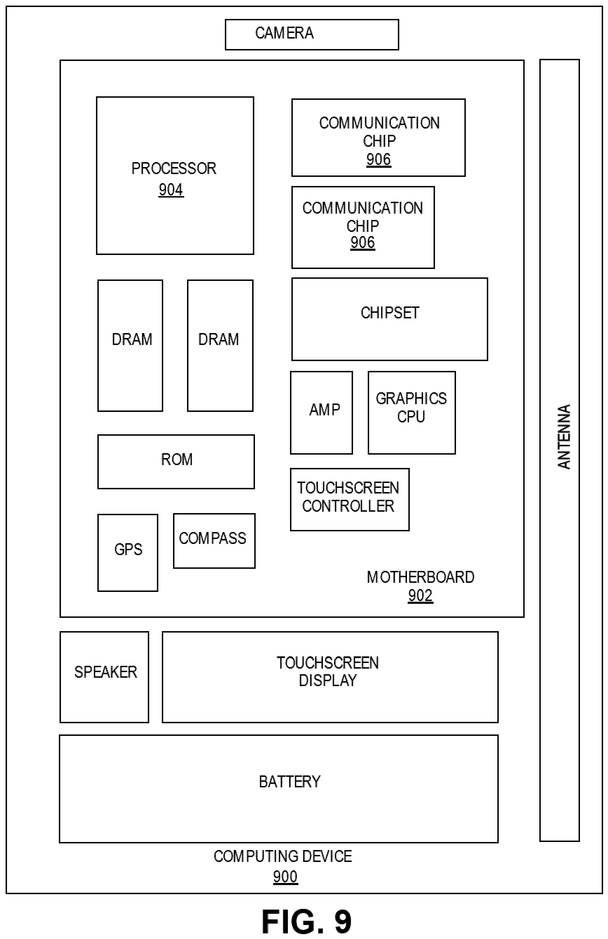

Figure 9 illustrates a computing device 900 in accordance with one implementation of the disclosure. The computing device 900 houses a board 902. The board 902 may include a number of components, including but not limited to a processor 904 and at least one communication chip 906. The processor 904 is physically and electrically coupled to the board 902. In some implementations the at least one communication chip 906 is also physically and electrically coupled to the board 902. In further implementations, the communication chip 906 is part of the processor 904.

Depending on its applications, computing device 900 may include other components that may or may not be physically and electrically coupled to the board 902. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 906 enables wireless communications for the transfer of data to and from the computing device 900. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 906 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 900 may include a plurality of communication chips 906. For instance, a first communication chip 906 may be dedicated to shorter range wireless communications such as Wi-Fi and Bluetooth and a second communication chip 906 may be dedicated to longer range wireless communications such as GPS, EDGE, GPRS, CDMA, WiMAX, LTE, Ev-DO, and others.

The processor 904 of the computing device 900 includes an integrated circuit die packaged within the processor 904. In some implementations of embodiments of the disclosure, the integrated circuit die of the processor includes one or more structures, such as integrated circuit structures built in accordance with implementations of the disclosure. The term "processor" may refer to any device or portion of a device that processes electronic data from registers or memory to transform that electronic data, or both, into other electronic data that may be stored in registers or memory, or both.

The communication chip 906 also includes an integrated circuit die packaged within the communication chip 906. In accordance with another implementation of the disclosure, the integrated circuit die of the communication chip is built in accordance with implementations of the disclosure.

In further implementations, another component housed within the computing device 900 may contain an integrated circuit die built in accordance with implementations of embodiments of the disclosure.

In various embodiments, the computing device 900 may be a laptop, a netbook, a notebook, an ultrabook, a smartphone, a tablet, a personal digital assistant (PDA), an ultramobile PC, a mobile phone, a desktop computer, a server, a printer, a scanner, a monitor, a set-top box, an entertainment control unit, a digital camera, a portable music player, or a digital video recorder. In further implementations, the computing device 900 may be any other electronic device that processes data.

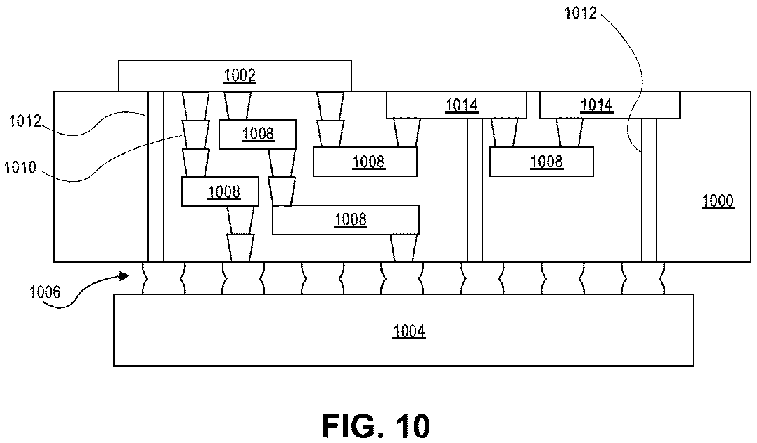

Figure 10 illustrates an interposer 1000 that includes one or more embodiments of the disclosure. The interposer 1000 is an intervening substrate used to bridge a first substrate 1002 to a second substrate 1004. The first substrate 1002 may be, for instance, an integrated circuit die. The second substrate 1004 may be, for instance, a memory module, a computer motherboard, or another integrated circuit die. Generally, the purpose of an interposer 1000 is to spread a connection to a wider pitch or to reroute a connection to a different connection. For example, an interposer 1000 may couple an integrated circuit die to a ball grid array (BGA) 1006 that can subsequently be coupled to the second substrate 1004. In some embodiments, the first and second substrates 1002/1004 are attached to opposing sides of the interposer 1000. In other embodiments, the first and second substrates 1002/1004 are attached to the same side of the interposer 1000. And, in further embodiments, three or more substrates are interconnected by way of the interposer 1000.

The interposer 1000 may be formed of an epoxy resin, a fiberglass-reinforced epoxy resin, a ceramic material, or a polymer material such as polyimide. In further implementations, the interposer 1000 may be formed of alternate rigid or flexible materials that may include the same materials described above for use in a semiconductor substrate, such as silicon, germanium, and other group III-V and group IV materials.

The interposer 1000 may include metal interconnects 1008 and vias 1010, including but not limited to through-silicon vias (TSVs) 1012. The interposer 1000 may further include embedded devices 1014, including both passive and active devices. Such devices include, but are not limited to, capacitors, decoupling capacitors, resistors, inductors, fuses, diodes, transformers, sensors, and electrostatic discharge (ESD) devices. More complex devices such as radio-frequency (RF) devices, power amplifiers, power management devices, antennas, arrays, sensors, and MEMS devices may also be formed on the interposer 1000. In accordance with embodiments of the disclosure, apparatuses or processes disclosed herein may be used in the fabrication of interposer 1000 or in the fabrication of components included in the interposer 1000.

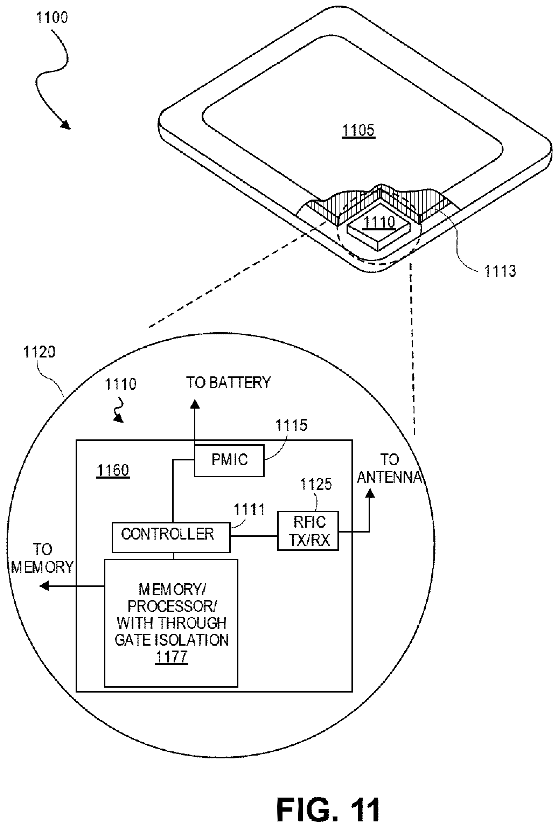

Figure 11 is an isometric view of a mobile computing platform 1100 employing an integrated circuit (IC) fabricated according to one or more processes described herein or including one or more features described herein, in accordance with an embodiment of the present disclosure.

The mobile computing platform 1100 may be any portable device configured for each of electronic data display, electronic data processing, and wireless electronic data transmission. For example, mobile computing platform 1100 may be any of a tablet, a smart phone, laptop computer, etc. and includes a display screen 1105 which in the exemplary embodiment is a touchscreen (capacitive, inductive, resistive, etc.), a chip-level (SoC) or package-level integrated system 1110, and a battery 1113. As illustrated, the greater the level of integration in the integrated system 1110 enabled by higher transistor packing density, the greater the portion of the mobile computing platform 1100 that may be occupied by the battery 1113 or non-volatile storage, such as a solid state drive, or the greater the transistor gate count for improved platform functionality. Similarly, the greater the carrier mobility of each transistor in the integrated system 1110, the greater the functionality. As such, techniques described herein may enable performance and form factor improvements in the mobile computing platform 1100.

The integrated system 1110 is further illustrated in the expanded view 1120. In the exemplary embodiment, packaged device 1177 includes at least one memory chip (e.g., RAM), or at least one processor chip (e.g., a multi-core microprocessor and/or graphics processor) fabricated according to one or more processes described herein or including one or more features described herein. The packaged device 1177 is further coupled to the board 1160 along with one or more of a power management integrated circuit (PMIC) 1115, RF (wireless) integrated circuit (RFIC) 1125 including a wideband RF (wireless) transmitter and/or receiver (e.g., including a digital baseband and an analog front end module further including a power amplifier on a transmit path and a low noise amplifier on a receive path), and a controller thereof 1111. Functionally, the PMIC 1115 performs battery power regulation, DC-to-DC conversion, etc., and so has an input coupled to the battery 1113 and with an output providing a current supply to all the other functional modules. As further illustrated, in the exemplary embodiment, the RFIC 1125 has an output coupled to an antenna to provide to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. In alternative implementations, each of these board-level modules may be integrated onto separate ICs coupled to the package substrate of the packaged device 1177 or within a single IC (SoC) coupled to the package substrate of the packaged device 1177.

In another aspect, semiconductor packages are used for protecting an integrated circuit (IC) chip or die, and also to provide the die with an electrical interface to external circuitry. With the increasing demand for smaller electronic devices, semiconductor packages are designed to be even more compact and must support larger circuit density. Furthermore, the demand for higher performance devices results in a need for an improved semiconductor package that enables a thin packaging profile and low overall warpage compatible with subsequent assembly processing.

In an embodiment, wire bonding to a ceramic or organic package substrate is used. In another embodiment, a C4 process is used to mount a die to a ceramic or organic package substrate. In particular, C4 solder ball connections can be implemented to provide flip chip interconnections between semiconductor devices and substrates. A flip chip or Controlled Collapse Chip Connection (C4) is a type of mounting used for semiconductor devices, such as integrated circuit (IC) chips, MEMS or components, which utilizes solder bumps instead of wire bonds. The solder bumps are deposited on the C4 pads, located on the top side of the substrate package. In order to mount the semiconductor device to the substrate, it is flipped over with the active side facing down on the mounting area. The solder bumps are used to connect the semiconductor device directly to the substrate.

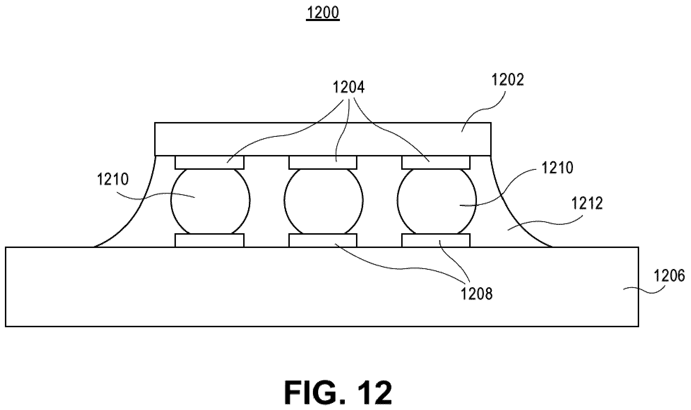

Figure 12 illustrates a cross-sectional view of a flip-chip mounted die, in accordance with an embodiment of the present disclosure.

Referring to Figure 12, an apparatus 1200 includes a die 1202 such as an integrated circuit (IC) fabricated according to one or more processes described herein or including one or more features described herein, in accordance with an embodiment of the present disclosure. The die 1202 includes metallized pads 1204 thereon. A package substrate 1206, such as a ceramic or organic substrate, includes connections 1208 thereon. The die 1202 and package substrate 1206 are electrically connected by solder balls 1210 coupled to the metallized pads 1204 and the connections 1208. An underfill material 1212 surrounds the solder balls 1210.

Processing a flip chip may be similar to conventional IC fabrication, with a few additional operations. Near the end of the manufacturing process, the attachment pads are metalized to make them more receptive to solder. This typically consists of several treatments. A small dot of solder is then deposited on each metalized pad. The chips are then cut out of the wafer as normal. To attach the flip chip into a circuit, the chip is inverted to bring the solder dots down onto connectors on the underlying electronics or circuit board. The solder is then re-melted to produce an electrical connection, typically using an ultrasonic or alternatively reflow solder process. This also leaves a small space between the chip's circuitry and the underlying mounting. In most cases an electrically-insulating adhesive is then "underfilled" to provide a stronger mechanical connection, provide a heat bridge, and to ensure the solder joints are not stressed due to differential heating of the chip and the rest of the system.

In other embodiments, newer packaging and die-to-die interconnect approaches, such as through silicon via (TSV) and silicon interposer, are implemented to fabricate high performance Multi-Chip Module (MCM) and System in Package (SiP) incorporating an integrated circuit (IC) fabricated according to one or more processes described herein or including one or more features described herein, in accordance with an embodiment of the present disclosure.

Thus, embodiments of the present disclosure include advanced integrated circuit structure fabrication.

Although specific embodiments have been described above, these embodiments are not intended to limit the scope of the present disclosure, even where only a single embodiment is described with respect to a particular feature. Examples of features provided in the disclosure are intended to be illustrative rather than restrictive unless stated otherwise. The above description is intended to cover such alternatives, modifications, and equivalents as would be apparent to a person skilled in the art having the benefit of the present disclosure.

The scope of the present disclosure includes any feature or combination of features disclosed herein (either explicitly or implicitly), or any generalization thereof, whether or not it mitigates any or all of the problems addressed herein. Accordingly, new claims may be formulated during prosecution of the present application (or an application claiming priority thereto) to any such combination of features. In particular, with reference to the appended claims, features from dependent claims may be combined with those of the independent claims and features from respective independent claims may be combined in any appropriate manner and not merely in the specific combinations enumerated in the appended claims.

The following examples pertain to further embodiments. The various features of the different embodiments may be variously combined with some features included and others excluded to suit a variety of different applications.
Example embodiment 1: An integrated circuit structure includes a first semiconductor fin having first fin sidewall spacers, and a second semiconductor fin having second fin sidewall spacers. A gate endcap structure is between the first and second semiconductor fins and laterally between and in contact with adjacent ones of the first and second fin sidewall spacers, the gate endcap structure including a gate electrode and a gate dielectric. A first source or drain contact is electrically coupled to the first semiconductor fin. A second source or drain contact is electrically coupled to the second semiconductor fin.
Example embodiment 2: The integrated circuit structure of example embodiment 1, wherein the gate endcap structure is on an N-type doped region of an underlying substrate, the first semiconductor fin includes an N-type region, and the second semiconductor fin includes a P-type region.
Example embodiment 3: The integrated circuit structure of example embodiment 1 or 2, further including a first N-type epitaxial semiconductor structure on the first semiconductor fin, wherein the first source or drain contact is on the first N-type epitaxial semiconductor structure. A second N-type epitaxial semiconductor structure is on the second semiconductor fin, wherein the second source or drain contact is on the second N-type epitaxial semiconductor structure.
Example embodiment 4: The integrated circuit structure of example embodiment 1 or 2, further including a first epitaxial semiconductor structure on the first semiconductor fin, wherein the first source or drain contact is on the first epitaxial semiconductor structure. A second epitaxial semiconductor structure is on the second semiconductor fin, wherein the second source or drain contact is on the second epitaxial semiconductor structure.
Example embodiment 5: The integrated circuit structure of example embodiment 1, 2, 3 or 4, further including a gate extension on the gate endcap structure, the gate extension electrically connected to the gate electrode of the gate endcap structure.
Example embodiment 6: The integrated circuit structure of example embodiment 5, wherein the gate extension includes dielectric sidewall spacers.
Example embodiment 7: The integrated circuit structure of example embodiment 1, 2, 3, 4, 5 or 6, wherein the gate endcap structure has a top surface above a top surface of the first semiconductor fin, and above a top surface of the second semiconductor fin.
Example embodiment 8: An integrated circuit structure includes a drain structure having a first epitaxial structure on a first semiconductor fin and a doped region in a substrate below the first semiconductor fin. A channel structure includes at least a portion of the second semiconductor fin. A source structure includes a second epitaxial structure on the second semiconductor fin. A gate structure is between the first and second semiconductor fins, the gate structure including a gate electrode and a gate dielectric.
Example embodiment 9: The integrated circuit structure of example embodiment 8, further including a drain contact on the first epitaxial structure, and a source contact on the second epitaxial structure.
Example embodiment 10: The integrated circuit structure of example embodiment 8 or 9, wherein the drain structure and the source structure are N-type, and the channel structure is P-type.
Example embodiment 11: The integrated circuit structure of example embodiment 8, 9 or 10, further including a gate extension on the gate structure, the gate extension electrically connected to the gate electrode of the gate structure.
Example embodiment 12: A computing device includes a board, and a component coupled to the board, the component including an integrated circuit structure. The integrated circuit structure includes a first semiconductor fin having first fin sidewall spacers, and a second semiconductor fin having second fin sidewall spacers. A gate endcap structure is between the first and second semiconductor fins and laterally between and in contact with adjacent ones of the first and second fin sidewall spacers, the gate endcap structure including a gate electrode and a gate dielectric. A first source or drain contact is electrically coupled to the first semiconductor fin. A second source or drain contact is electrically coupled to the second semiconductor fin.
Example embodiment 13: The computing device of example embodiment 12, further including a memory coupled to the board.
Example embodiment 14: The computing device of example embodiment 12 or 13, further including a communication chip coupled to the board.
Example embodiment 15: The computing device of example embodiment 12, 13 or 14, further including a camera coupled to the board.
Example embodiment 16: The computing device of example embodiment 12, 13, 14 or 15, further including a battery coupled to the board.
Example embodiment 17: The computing device of example embodiment 12, 13, 14, 15 or 16, further including an antenna coupled to the board.
Example embodiment 18: The computing device of example embodiment 12, 13, 14, 15, 16 or 17, wherein the component is a packaged integrated circuit die.
Example embodiment 19: The computing device of example embodiment 12, 13, 14, 15, 16, 17 or 18, wherein the component is selected from the group consisting of a processor, a communications chip, and a digital signal processor.
Example embodiment 20: The computing device of example embodiment 12, 13, 14, 15, 16, 17, 18 or 19, wherein the computing device is selected from the group consisting of a mobile phone, a laptop, a desk top computer, a server, and a set-top box.

## Claims

1. An integrated circuit structure, comprising:
a first semiconductor fin having first fin sidewall spacers;
a second semiconductor fin having second fin sidewall spacers;
a gate endcap structure between the first and second semiconductor fins and laterally between and in contact with adjacent ones of the first and second fin sidewall spacers, the gate endcap structure comprising a gate electrode and a gate dielectric;
a first source or drain contact electrically coupled to the first semiconductor fin; and
a second source or drain contact electrically coupled to the second semiconductor fin.

2. The integrated circuit structure of claim 1, wherein the gate endcap structure is on an N-type doped region of an underlying substrate, the first semiconductor fin comprises an N-type region, and the second semiconductor fin comprises a P-type region.

3. The integrated circuit structure of claim 1 or 2, further comprising:
a first N-type epitaxial semiconductor structure on the first semiconductor fin, wherein the first source or drain contact is on the first N-type epitaxial semiconductor structure; and
a second N-type epitaxial semiconductor structure on the second semiconductor fin, wherein the second source or drain contact is on the second N-type epitaxial semiconductor structure.

4. The integrated circuit structure of claim 1 or 2, further comprising:
a first epitaxial semiconductor structure on the first semiconductor fin, wherein the first source or drain contact is on the first epitaxial semiconductor structure; and
a second epitaxial semiconductor structure on the second semiconductor fin, wherein the second source or drain contact is on the second epitaxial semiconductor structure.

5. The integrated circuit structure of claim 1, 2, 3 or 4, further comprising:
a gate extension on the gate endcap structure, the gate extension electrically connected to the gate electrode of the gate endcap structure.

6. The integrated circuit structure of claim 5, wherein the gate extension comprises dielectric sidewall spacers.

7. The integrated circuit structure of claim 1, 2, 3, 4, 5 or 6, wherein the gate endcap structure has a top surface above a top surface of the first semiconductor fin, and above a top surface of the second semiconductor fin.

8. A method of fabricating an integrated circuit structure, the method comprising:
forming a first semiconductor fin having first fin sidewall spacers;
forming a second semiconductor fin having second fin sidewall spacers;
forming a gate endcap structure between the first and second semiconductor fins and laterally between and in contact with adjacent ones of the first and second fin sidewall spacers, the gate endcap structure comprising a gate electrode and a gate dielectric;
forming a first source or drain contact electrically coupled to the first semiconductor fin; and
forming a second source or drain contact electrically coupled to the second semiconductor fin.

9. The method of claim 8, wherein the gate endcap structure is on an N-type doped region of an underlying substrate, the first semiconductor fin comprises an N-type region, and the second semiconductor fin comprises a P-type region.

10. The method of claim 8 or 9, further comprising:
forming a first N-type epitaxial semiconductor structure on the first semiconductor fin, wherein the first source or drain contact is on the first N-type epitaxial semiconductor structure; and
forming a second N-type epitaxial semiconductor structure on the second semiconductor fin, wherein the second source or drain contact is on the second N-type epitaxial semiconductor structure.

11. The method of claim 8 or 9, further comprising:
forming a first epitaxial semiconductor structure on the first semiconductor fin, wherein the first source or drain contact is on the first epitaxial semiconductor structure; and
forming a second epitaxial semiconductor structure on the second semiconductor fin, wherein the second source or drain contact is on the second epitaxial semiconductor structure.

12. The method of claim 8, 9, 10 or 11, further comprising:
forming a gate extension on the gate endcap structure, the gate extension electrically connected to the gate electrode of the gate endcap structure.

13. The method of claim 12, wherein the gate extension comprises dielectric sidewall spacers.

14. The method of claim 8, 9, 10, 11, 12 or 13, wherein the gate endcap structure has a top surface above a top surface of the first semiconductor fin, and above a top surface of the second semiconductor fin.
